Europäisches Patentamt

European Patent Office

Office européen des brevets

(11) Veröffentlichungsnummer: **0 184 146**

**A1**

(12) # EUROPÄISCHE PATENTANMELDUNG

(21) Anmeldenummer: **85115122.5**

(22) Anmeldetag: **28.11.85**

(51) Int. Cl.⁴: **H 01 L 23/42**

(30) Priorität: **04.12.84 DE 3444173**

(43) Veröffentlichungstag der Anmeldung:
**11.06.86 Patentblatt 86/24**

(84) Benannte Vertragsstaaten:
**CH DE FR IT LI**

(71) Anmelder: **BBC Aktiengesellschaft Brown, Boveri & Cie.
Haselstrasse
CH-5401 Baden(CH)**

(72) Erfinder: **Klein, Erwin
Dresdner Strasse 5
D-6805 Heddesheim(DE)**

(74) Vertreter: **Kempe, Wolfgang, Dr. et al,
c/o Brown, Boveri & Cie AG Postfach 351
D-6800 Mannheim 1(DE)**

(54) **Dosen-Siedekühleinrichtung für Leistungshalbleiterelemente.**

(57) Siedekühleinrichtung für Leistungshalbleiterelemente, die mit Kühldosen (2) abwechselnd zu einer horizontal angeordneten Säule gestapelt sind, wobei die Kühldosen eine elektrisch isolierende, beim Betrieb der Halbleiterelemente (1) verdampfenden Kühlflüssigkeit enthalten und der in den Kühldosen entstehende Dampf einem Rückkühler (30) zugeleitet und das im Rückkühler niedergeschlagene Kondensat den Kühldosen zugeleitet wird. Um eine ausreichende Isolierung der spannungsführenden Kühldosen untereinander und gegenüber dem Rückkühler zu erreichen wird der Rückkühler unmittelbar oberhalb der Leistungshalbleiter-Kühldosen-Säule angeordnet und die elektrische Trennung der spannungsführenden Kühldosen untereinander und gegenüber dem Rückkühler erfaßt durch elektrisch isolierende Verbindungsteile, insbesondere einen keramischen Flansch (17) und elektrisch isolierende vertikale Kondensatleitungen (28) für die einzelnen Kühldosen.

EP 0 184 146 A1

0184146

BBC AKTIENGESELLSCHAFT
Brown,Boveri & Cie.                    Baden/Schweiz
Mp.Nr. 672/84                          28. Nov. 1984
                                       ZPT/P2-Sz/Fo

## Dosen-Siedekühleinrichtung für Leistungshalbleiterelemente

Die Erfindung bezieht sich auf eine Siedekühleinrichtung für Leistungshalbleiterelemente, die mit Kühldosen abwechselnd zu einer horizontal angeordneten Säule gestapelt sind, wobei die Kühldosen Verdampfer-Hohlräume zur Aufnahme einer elektrisch isolierenden, beim Betrieb der Halbleiterelemente verdampfenden Kühlflüssigkeit aufweisen und eine Kühlmittelkreislauf zwischen den Kühldosen und einem Rückkühler gebildet wird, in dem der in den Kühldosen entstehende Dampf dem Rückkühler über Rohrleitungen zugeleitet und das im Rückkühler niedergeschlagene Kondensat über Rohrleitungen an den Kühldosen abgeleitet wird. Die Rohrleitungen für Kondensat und Dampf können vorteilhaft ineinander angeordnet sein.

Derartige Dosen-Siedekühleinrichtungen für Halbleiterelemente sind in der Patentanmeldung P 33 07 703.7 beschrieben. Diese Siedekühleinrichtungen haben sich in

Mp.Nr. 672/84                                    2              **0184146**

vielen Fällen bewährt, jedoch hat es sich gezeigt, daß
diese Ausführung nicht bei allen Einsatzfällen optimal
ist. Wenn man z.B. gezwungen ist, den Rückkühler direkt
über den aus Kühldosen, Halbleiterelementen und
Spanneinrichtungen bestehenden Säulen anzuordnen, dann
baut diese Kombination mindestens um die Höhe des Dampfsammelrohres, wenn angenommen wird, daß der Rückkühler
höher ist als die Höhe des Dampfsammelrohres, größer als
wenn dieses nicht vorhanden wäre. Eine Höhenreduzierung
kann man nicht bei gleicher Länge der vertikalen Dampfleitung dadurch erzielen, daß man das flexible Wellrohr
aus Metall aus Kunststoff herstellt, da in einem derartigen Fall Dampfdiffusion eintritt und somit schädliches
Wasser in das Kältemittel einsickert.

Aufgabe der Erfindung ist es daher, eine Lösung zur ausreichenden Isolierung der spannungsführenden Kühldosen
untereinander und gegenüber dem Rückkühler zu suchen.

Gemäß der Erfindung wird diese Aufgabe dadurch gelöst,
daß der Rückkühler unmittelbar oberhalb der Leistungshalbleiter-Kühldosen-Säule angeordnet und die elektrische Trennung der spannungsführenden Kühldosen untereinander und gegenüber dem Rückkühler durch elektrisch isolierende Verbindungsteile, insbesondere einen keramischen Flansch und elektrisch isolierende vertikale Kondensatleitungen für die einzelnen Kühldosen erfolgt. Die
Erfindung ist jedoch nicht auf die Anorung des Rückkühlers unmittelbar oberhalb der Leistungshalbleiter-Säule
beschränkt, sondern kann auch angewandt werden, wenn der
in den Kühldosen entstehende Dampf dem Rückkühler über
horizontale Dampfsammelleitungen und vertikale Dampfleitungen zugeleitet und das im Rückkühler
niedergeschlagene Kondensat über horizontale Kondensatsammelleitungen und vertikale Kondensatleitungen an die
Kühldosen abgeleitet wird. In diesem Fall wird die elektrische Trennung der spannungsführenden Kühldosen

0184146

untereinander und gegenüber dem Rückkühler durch elektrisch isolierende Verbindungsteile, insbesondere einen keramischen Flansch und elektrisch isolierende vertikale Kondensatleitungen für die einzelnen Kühldosen erreicht.

Die Erfindung wird nachstehend anhand der in den Zeichnungen dargestellten Ausführungsformen erläutert.

Es zeigen:

Fig. 1      Eine Draufsicht auf einen Teil einer Halbleitersäule mit Siedekühleinrichtung und Rückkühler,

Fig. 2      einen Schnitt durch eine Seitenansicht dieser Säule,

Fig. 3      einen Flansch mit integriertem Flüssigkeitsrohr und

Fig. 4      ein Teilschnitt entlang der Linie IV-IV der Fig. 3.

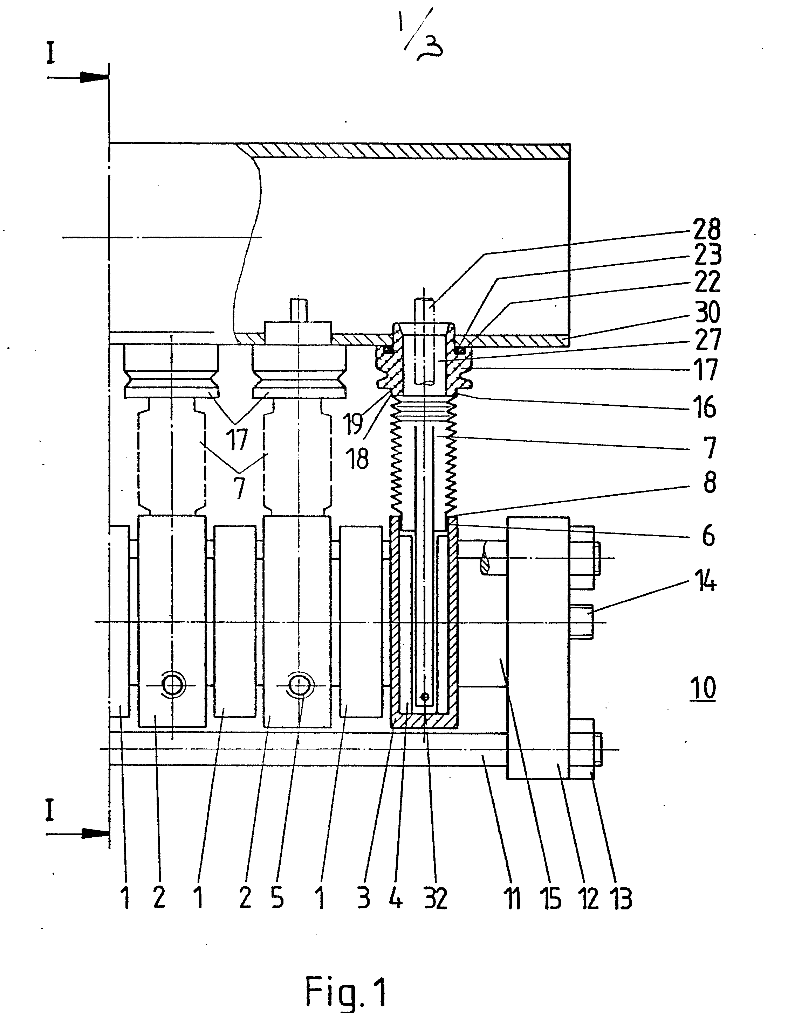

In Figur 1 ist eine Draufsicht auf einen Teil einer Halbleitersäule mit Dosen-Siedekühleinrichtung dargestellt. Mehrere Leistungshalbleiterelemente 1 sind abwechselnd mit metallischen Kühldosen 2, welche aus elektrisch und thermisch gut leitendem Material bestehen, zu einer Säule geschichtet. Als Halbleiterelemente 1 werden in diesem Zusammenhang Leistungsdioden oder Leistungsthyristoren in Metall-Keramik-Gehäusen verstanden. Die so entstandene Säule weist Halbleiterelemente 1 und n+1 Kühldosen 2 auf.

Die Kühldosen 2 können z.B. aus je zwei gleichen Halbschalen bestehen, in deren inneren Hohlräumen von den Kühldosenböden 3 aus sich zur Vergrößerung der Siedeflächen Rippen 4 erstrecken. Die Halbschalen der Kühldosen 2 sind stoffschlüssig miteinander verbunden. Zum elektrischen Anschluß sind die Kühldosen 2 mit mindestens einem Gewindeloch 5 versehen.

In einer im oberen Teil der Kühldose 2 befindlichen Bohrung 6 für hydraulischen Anschluß ist eine vertikale Dampfleitung 7 (Gasleitung) mit ihrem einen Ende 8 eingelötet. Die vertikale Dampfleitung 7 besteht aus einem metallischen Wellrohr.

Die aus Halbleiterelementen 1 und Kühldosen 2 bestehende Säule wird über eine Kontakteinrichtung 10 (Spanneinrichtung für thermische und elektrische Kontaktierung) kraftschlüssig kontaktiert. Die Kontakteinrichtung 10 kann z.B. aus drei Zugstäben 11 bestehen, die zwei Jochplatten 12 verbindet (es ist nur eine der Jochplatten 12) dargestellt, die über Muttern 13 verspannt werden. Um die Kontaktkraft definiert aufzubringen, stützen sich in den Jochplatten 12 nicht dargestellte Tellerfedern ab. Deren Reaktionskräfte werden über Schrauben 14 und Isolatoren 15 auf die Kühldosen 2 aufgebracht. Die Isolatoren 15 können entfallen, wenn die Zugstäbe 11 elektrisch isoliert ausgeführt werden und auch die Befestigung der Säule elektrisch isoliert erfolgt.

Die vertikale Dampfleitung 7 besitzt an ihrem zweiten Ende einen Bund 16, der an einem flanschartigen Verbindungsteil 17 befestigt wird. Für diese Befestigung ist ein Bund 18 vorgesehen, der eine Metallisierung 19 trägt, so daß eine stoffschlüssige Verbindung möglich ist.

Das flanschartige Verbindungsteil 17 besteht aus einer Oxidkeramik, im speziellen aus $Al_2O_3$. Eine ovale Befestigungsplatte ist mit zwei Befestigungsbohrungen 21 und einer kreisförmigen Nut 22 zur Aufnahme eines Dichtungsringes 23 versehen. Von der Platte 20 aus ersteckt sich ein zylinderförmiges Teil 24 nach oben und ein zweites 25 nach unten. Dieses Teil ist mit einer Nut 26 zur Kriechwegverlängerung und dem Bund 18 mit der Metallisierung 19 versehen. Durch die Platte 20 und die beiden zylinderförmigen Teile 24 und 25 führt eine Bohrung 27. Das zur vertikalen Dampfleitung 7 konzentrisch angeordnete Flüssigkeitsrohr 28 ist nur angedeutet.

Das Verbindungsteil 17 wird mittels der Schrauben 29 an dem Teil 30 befestigt. Dieses Teil 30 kann ein metallisches Dampfsammelrohr sein, es kann aber auch der unmittelbar über der Halbleitersäule angeordnete Rückkühler darstellen. Falls es sich um eine Dampfsammenleitung handelt, so wird das vertikale Flüssigkeitsrohr 28 mit einer nicht dargestellten horizontalen Kondensatsammelleitung verbunden. Es muß in jedem Fall dafür gesorgt sein, das daß Kondensatniveau 31 in dem Rückkühler 30 bzw. in dem Dampfsammelrohr 30 genügend hoch ist, damit die Versorgung mit Kondensatflüssigkeit ausreichend ist.

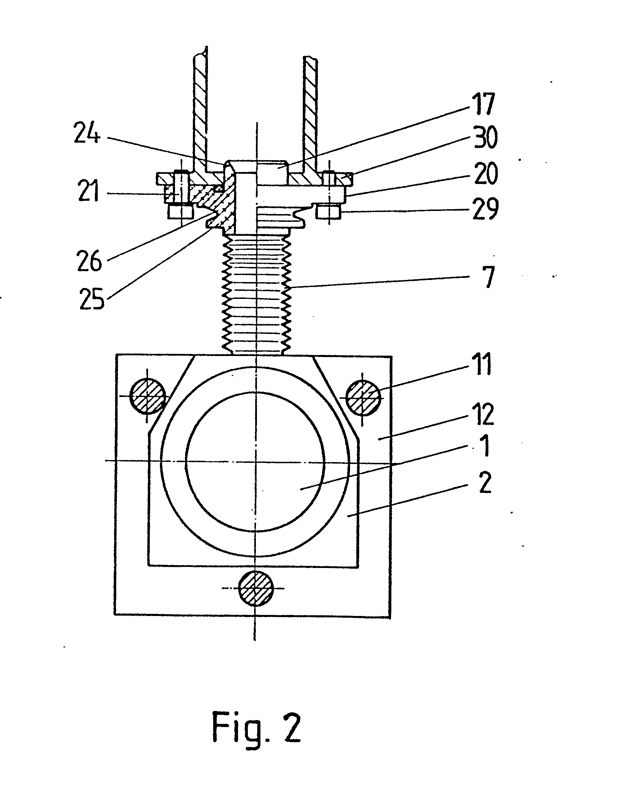

In Figur 2 ist ein Schnitt durch eine Seitenansicht einer Halbleitersäule dargestellt. Im einzelnen sind ein Leistungshableiterelmente 1, eine Kühldose 2 mit vertikaler Dampfleitung 7 und dem flanschartigen Verbindungsteil 17 dargestellt.

Die vertikalen Kondensatleitungen 28 erstrecken sich vorzugsweise bis fast zum Grund der Kühldosen 2. Dabei ist keine besondere Dichtheit an den Verbindungen mit den nicht dargestellten horizontalen Kondensatsammelleitungen erforderlich. Die vertikalen Kondensatleitungen 28 können aus dünnem Kunststoff hergestellt werden, so daß genügend Beweglichkeit zum Toleranzausgleich gegeben ist. Die vertikale Kondensatleitung 28 besitzt an ihrem unteren Ende mehrere Bohrungen 32, so daß die Flüssigkeit nicht in axialer Richtung, sondern seitlich in den

0184146

Hohlraum der Kühldose austreten kann.

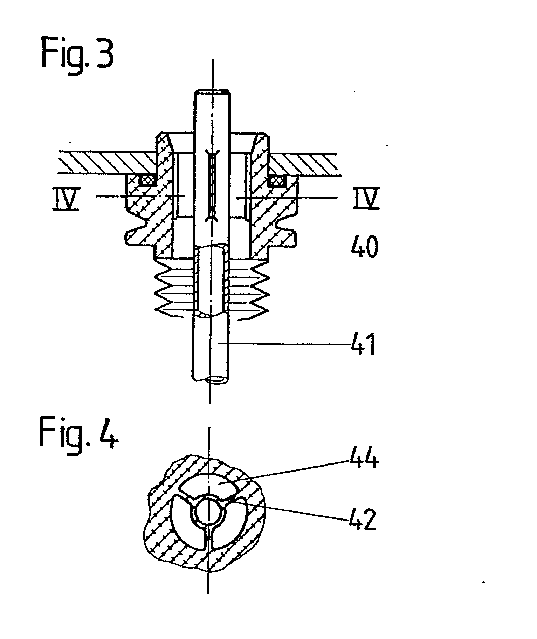

In den Figuren 3 und 4 ist gezeigt, wie in dem Flansch 40, der in seinen äußeren Abmessungen dem flanschartigen Verbindungsteil 17 der Figur 1 entspricht, das vertikale Kondensatrohr 28 als integriertes Flüssigkeitsrohr 41 ausgeführt ist. Es besteht auch aus Oxidkeramik und ist über drei Rippen 42 an der Wandung der Bohrung 44 angebunden.

A n s p r ü c h e

1. Siedekühleinrichtung für Leistungshalbleiterelemente, die mit Kühldosen abwechselnd zu einer horizontal angeordneten Säule gestapelt sind, wobei die Kühldosen Verdammpfer-Hohlräume zur Aufnahme einer elektrischen Isolierung, beim Betrieb der Halbleiterelemente verdampfenden Kühlflüssigkeit aufweisen und ein Kühlmittelkreislauf zwischen den Kühldosen und einem Rückkühler gebildet wird, in dem der in Kühldosen entstehende Dampf dem Rückkühler über Rohrleitungen zugeleitet und das im Rückkühler niedergeschlagene Kondensat über Rohrleitungen an die Kühldosen abgeleitet wird, dadurch gekennzeichnet, daß es möglichst den Rückkühler unmittelbar oberhalb der Leistungshalbleiter-Kühldosen-Säule anzuordnen und die elektrische Trennung der spannungsführenden Kühldosen (2) untereinander und gegenüber dem Rückkühler durch elektrisch isolierende Verbindungsteile, insbesondere einen keramischen Flansch und elektrisch isolierende vertikale Kondensatleitungen (28) für die einzelnen Kühldosen (2) erfolgt.

2. Siedekühleinrichtung für Leistungshalbleiterelemente, die mit Kühldosen abwechselnd zu einer Säule gestapelt sind, wobei die Kühldosenverdampfer-Hohlräume zur Aufnahme einer elektrisch isolierenden, bei Betrieb der Halbleiterelemente verdampfenden Kühlflüssigkeit aufweisen und ein Kühlmittelkreislauf zwischen den Kühldosen und einem Rückkühler gebildet wird, in dem der in den Kühldosen entstehende Dampf dem Rückkühler über horizontale Dampfsammelleitungen und vertikale Dampfleitungen zugeleitet und das im Rückkühler niedergeschlagene Kondensat über horizontale Kondensatsammelleitungen und vertikale Kondensatleitungen an die Kühldosen

abgeleitet wird, dadurch gekennzeichnet, daß die elektrische Trennung der spannungsführenden Kühldosen (2) untereinander und gegenüber dem Rückkühler durch elektrisch isolierende Verbindungsteile, insbesondere einen keramischen Flansch und elektrisch isolierende vertikale Kondensatleitungen (28) für die einzelnen Kühldosen (2) erfolgt.

3. Siedekühleinrichtung nach einem der Ansprüche 1 und 2, dadurch gekennzeichnet, daß die stoffschlüssige Verbindung zwischen Flansch und Wellrohr durch Löten erfolgt.

4. Siedekühleinrichtung nach einem der Ansprüche 1 und 2, dadurch gekennzeichnet, daß die stoffschlüssige Verbindung zwischen Flansch und Wellrohr durch Thermokompression erfolgt.

5. Siedekühleinrichtung nach einem der Ansprüche 1 oder 2, dadurch gekennzeichnet, daß das vertikale Kondensatrohr (28) integrierter Bestandteil des Flansches (17) ist.

Fig.1

0184146

Fig. 2

0184146

Fig. 3

IV          IV

40

41

Fig. 4

44

42

# 0184146

Nummer der Anmeldung

## EUROPÄISCHER RECHERCHENBERICHT

Europäisches Patentamt

EP  85 11 5122

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl.4) |
|---|---|---|---|
| A,D | DE-A-3 307 703 (BBC) <br> * Ansprüche 1-4 * <br> --- | 1,2 | H 01 L 23/42 |
| A | PATENT ABSTRACTS OF JAPAN, Band 5, Nr. 192 (E-85)[864], 8. Dezember 1981; & JP - A - 56 115 549 (MITSUBISHI) 10.09.1981 <br> --- | 1,2 | |
| A | PATENT ABSTRACTS OF JAPAN, Band 6, Nr. 173 (E-129)[1051], 7. September 1982; & JP - A - 57 91544 (TOYO DENKI SEIZO) 07.06.1982 <br> ----- | 1,2 | |

| | RECHERCHIERTE SACHGEBIETE (Int. Cl.4) |
|---|---|
| | H 01 L  23/10 <br> H 01 L  23/34 <br> H 01 L  25/14 |

Der vorliegende Recherchenbericht wurde für alle Patentansprüche erstellt.

| Recherchenort <br> BERLIN | Abschlußdatum der Recherche <br> 12-02-1986 | Prüfer <br> GIBBS C.S. |
|---|---|---|